# EUROPEAN PATENT SPECIFICATION

(11) **EP 4 095 888 B1**
(45) Date of publication and mention of the grant of the patent: **18.12.2024**
(21) Application number: 21176547.4
(22) Date of filing: 28.05.2021
(51) Int. Cl.: H01L 21/329, H01L 21/331, H01L 29/16, H01L 29/04, H01L 29/06, H01L 29/32, H01L 29/732, H01L 29/739, H01L 29/861, H01L 29/872

(54) **SEMICONDUCTOR DEVICE HAVING A REDUCED CONCENTRATION OF CARBON VACANCIES AND METHOD FOR MANUFACTURING A SEMICONDUCTOR DEVICE**
HALBLEITERBAUELEMENT MIT EINER REDUZIERTEN KONZENTRATION AN KOHLENSTOFFVAKANZEN UND VERFAHREN ZUR HERSTELLUNG EINES HALBLEITERBAUELEMENTS
DISPOSITIF SEMI-CONDUCTEUR AYANT UNE CONCENTRATION RÉDUITE DE LACUNES DE CARBONE ET PROCÉDÉ DE FABRICATION D'UN DISPOSITIF SEMI-CONDUCTEUR

(43) Date of publication of application: 30.11.2022
(73) Proprietor: Hitachi Energy Ltd, 8050 Zürich (CH)
(72) Inventor: ALFIERI, Giovanni, 5103 Möriken (CH); KNOLL, Lars, 5607 Hägglingen (CH)
(74) Representative: Epping - Hermann - Fischer

(56) References cited:
- US-A1- 2013 183 820
- US-A1- 2014 361 312
- US-A1- 2015 108 500
- US-A1- 2015 333 190
- US-B1- 9 093 568

## Description

The present disclosure relates to semiconductor devices comprising at least one epitaxial layer made from a first semiconductor material comprising carbon, wherein at least one part of the epitaxial layer has a reduced concentration of carbon vacancies with respect to the first semiconductor material of the at least one epitaxial layer as-grown. The present disclosure further relates to methods for manufacturing such semiconductor devices.

US 7 754 589 B2 relates to a method for improving the quality of a SiC layer by effectively reducing or eliminating the carrier trapping centers in the as-grown SiC crystal.

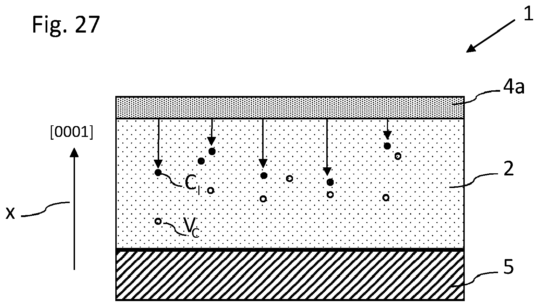

The process described in the following with reference to fig. 27, which is based on the implantation of C atoms into the top surface of a SiC epitaxial layer, is similar to one of the alternative processes disclosed in this document.

US2013/183820 A1 discloses a further method to reduce the carbon vacancy concentration in a SiC semiconductor body. That method comprises forming trenches in a SiC body by means of RIE followed by thermal etching, forming a C-rich layer on the sidewalls of said trenches and diffusing them into the semiconductor body by heat treatment.

US 2014/361312 A1 relates to a SiC reverse blocking MOSFET that includes an active region including a MOS gate structure and a breakdown voltage structure portion surrounding the outer circumference of the active region, which are provided on the surface side of a SiC-n- drift layer that is grown on one main surface of a p+ SiC substrate.

US 2015/333190 A1 relates to a semiconductor device that includes a semiconductor layer made of a wide bandgap semiconductor, a trench that is selectively formed on a surface portion of the semiconductor layer and that defines a unit cell having a predetermined shape on the surface portion, and a surface electrode that is embedded in the trench so as to cover an upper surface of the unit cell and that forms a Schottky junction between the unit cell and the surface electrode, and side surfaces of the trench are formed of only a plurality of planes that have plane orientations crystallographically equivalent to each other.

US 2015/108500 A1 discloses a semiconductor device comprising a semiconductor body of a first semiconductor material, wherein at least a part of the semiconductor body constitutes a drift zone of a first conductivity type. The semiconductor device further comprises a channel layer structure comprising a semiconductor heterojunction between first and second semiconductor layers electrically coupled to the drift zone. The first and second semiconductor layers include semiconductor materials that are different to the first semiconductor material.

US 9 093 568 B1 discloses that, in a semiconductor diode a semiconductor body includes an injection efficiency control region between a drift region of a first conductivity type and a first electrode region of a second, opposite conductivity type. The injection efficiency control region includes a superjunction structure including a barrier region of the first conductivity type and a compensation region of a second conductivity type arranged consecutively along a lateral direction and directly adjoining each other. A net dopant concentration of the barrier region averaged along a vertical extension of the barrier region is at least three times greater than a net dopant concentration of the drift region averaged along 20% of a vertical extension of the drift zone adjoining the barrier region.

Embodiments of the disclosure relate to improved semiconductor devices and methods for their manufacturing. Exemplarily, there is a need for semiconductor devices that have an improved lifetime, low defect density and/or can be manufactured in a flexible way using conventional semiconductor processing steps.

The invention is defined by the attached set of claims. Further details of the disclosed devices and methods are provided in the following, which are helpful for understanding the claimed invention.

According to a first aspect, a semiconductor device comprising at least one epitaxial layer made from a first semiconductor material comprising carbon and having a [0001] crystallographic axis is provided. At least one implantation area is formed at a sidewall of the epitaxial layer, a normal direction of the sidewall being perpendicular to the [0001] crystallographic axis. At least one part of the epitaxial layer has a reduced concentration of carbon vacancies with respect to the first semiconductor material of the at least one epitaxial layer as-grown.

The at least one at least one epitaxial layer made from a first semiconductor material comprises at least one of n-type 4H-SiC or n-type 6H-SiC semiconductor material. The at least one implantation area comprises an implanted species, comprising at least one of carbon ions or silicon ions. The at least one part of the epitaxial layer is adjacent to the sidewall and has a concentration of carbon vacancy Z_{1/2} of below 10¹⁰/cm³.

By providing an implantation area at a sidewall of an epitaxial layer, implantation can be performed independent of other processing steps, which are typically performed in parallel to the [0001] crystallographic axis, e.g. on or through the front face of the epitaxial layer. At the same time, motility of an implanted species is improved, which simplifies a later annealing of the at least one epitaxial layer and results in a reduced concentration of carbon vacancies therein.

According to at least one embodiment, the at least one implantation area is formed on one of a plurality of sidewalls of at least one semiconductor chip comprising the at least one epitaxial layer. Implanting a species through a sidewall of a semiconductor chip allows the reduction of carbon vacancies on already separated, almost finished semiconductor circuit component.

According to at least one embodiment, the semiconductor device comprises at least one trench having two sidewalls formed in the at least one epitaxial layer. The at least one implantation area is formed on at least one of the two sidewalls of the at least one trench. The at least one part of the epitaxial layer corresponds to a sublayer extending in a plane perpendicular to the [0001] crystallographic axis, wherein a thickness of the sublayer corresponds to or exceeds a depth of the at least one trench. Use of trenches allows the implantation of a species on a vertical side-wall of an epitaxial layers having a relatively large spatial extent.

In at least one embodiment, the semiconductor device further comprises at least one electrode formed on a top or bottom surface of the at least one epitaxial layer, thereby forming an electrically active area, wherein the at least one implantation area is formed outside of an electrically active area. For example, the at least one implantation area may be formed in spatial proximity to the electrically active area of the semiconductor device. Such a spatial arrangement allows the reduction of carbon vacancies in the electrically active area without disturbing any elements within the electrically active area implementing a function of the semiconductor device.

For example, the at least one implantation area may comprises an implantation defect area, comprising amorphous silicon.

According to different embodiments, the semiconductor device may comprise different power electronic components, such as a PIN diode, a BJT, an IGBT, or a JBS diode.

According to a second aspect of the disclosure, a method for manufacturing a semiconductor device is provided. The method comprises growing at least one epitaxial layer made from a first semiconductor material comprising carbon and having a [0001] crystallographic axis, and implanting ions through at least one sidewall of the at least one epitaxial layer in a direction perpendicular to the [0001] crystallographic axis to form at least one implantation area, thereby reducing a concentration of carbon vacancies in the first semiconductor material with respect to the at least one epitaxial layer as-grown.

The at least one at least one epitaxial layer made from a first semiconductor material comprises at least one of n-type 4H-SiC or n-type 6H-SiC semiconductor material. The implanted ions in particular comprise at least one of carbon ions and silicon ions. The first semiconductor material of the finished semiconductor device has a concentration of carbon vacancy Z_{1/2} of below 10¹⁰/cm³.

The above steps enable the manufacturing of a semiconductor device according to first aspect. They enable an improved degree of flexibility during manufacturing. In particular, the step of implanting ions can be performed towards the end of the manufacturing process after other steps negatively affecting carbon vacancies of the at least one epitaxial layer have been completed.

According to at least one embodiment, the method further comprises at least one of annealing or proton irradiating the at least one epitaxial layer to further reduce the concentration of carbon vacancies in the first semiconductor material with respect to the at least one epitaxial layer after implanting ions. Annealing or proton irradiation helps to diffuse generated carbon interstitials.

According to at least one embodiment, before implanting ions through at least one sidewall, the method further comprises: performing a plurality of processing steps to form at least one semiconductor circuit component comprising at least parts of the at least one epitaxial layer; and separating the at least one semiconductor circuit component to obtain a semiconductor chip having a top surface perpendicular to the [0001] crystallographic axis and a plurality of sidewalls perpendicular to the top surface. Implanting ions through sidewalls of semiconductor chips enables the reduction of carbon vacancies in a separated, essentially finished semiconductor component.

According to another embodiment, the method further comprises forming at least one trench having two sidewalls within the at least one epitaxial layer, wherein implanting ions through at least one sidewall comprises plasma immersion ion implanting (PIII) of at least one of carbon (C) ions or silicon (Si) ions through the two sidewalls of the at least one trench.

Further aspects, embodiments and advantages of the present invention are disclosed in the following detailed description of embodiments as well as the attached set of claims.

The method for manufacturing a semiconductor device according to the second aspect described above is particularly suitable for manufacturing the semiconductor device according to the first aspect. Features and advantages described in connection with the semiconductor device can therefore be used in the manufacturing method and vice versa.

Thus, every feature described with respect to one of the aspects is also disclosed herein with respect to the other aspect, even if the respective feature is not explicitly mentioned in the context of the specific aspect.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figure 1 shows, in a schematic manner, a semiconductor device according to an embodiment of the disclosure.
Figure 2 shows, in a schematic manner, a method for manufacturing a semiconductor device according to an embodiment of the disclosure.
Figure 3 shows DLTS spectra of an epitaxial layer according to Figure 1 before and after implanting and annealing.
Figures 4 to 6 show steps for manufacturing a PIN diode according to an embodiment of the disclosure.
Figures 7 to 10 show steps for manufacturing a BJT according to an embodiment of the disclosure.
Figures 11 and 12 show steps for manufacturing an IGBT according to an embodiment of the disclosure.
Figure 13 shows, in a schematic manner, a semiconductor device comprising a trench according to an embodiment of the disclosure.
Figure 14 shows DLTS spectra of an epitaxial layer according to Figure 13 before and after implantation and annealing.
Figures 15 to 19 show steps for manufacturing a JBS diode according to another embodiment of the disclosure.
Figures 20 to 22 show steps for manufacturing a BJT according to another embodiment of the disclosure.
Figures 23 to 25 show steps for manufacturing an IGBT according to another embodiment of the disclosure.
Figure 26 shows, in a schematic manner, a method for producing a semiconductor device according to an embodiment of the disclosure.
Figure 27 shows, in a schematic manner, the removal of carbon vacancies through a top surface of a semiconductor device, which is part of the technological background of the present invention.

While the disclosure is amenable to various modifications and alternative forms, specifics thereof have been shown by way of example in the figures and will be described in detail. It should be understood, however, that the intention is not to limit the disclosure to the particular embodiments described. On the contrary, the intention is to cover all modifications, equivalents, and alternatives falling within the scope of the disclosure defined by the appended claims.

Before various embodiments of the present disclosure are described in more detail, at first some challenges encountered in conventional silicon carbide semiconductor materials and their processing are discussed.

The so-called carbon vacancy (V_{C}) is a technologically relevant, electrically active point defect in n-type 4H silicon carbide (4H-SiC). The presence of carbon vacancy gives rise to two levels in the bandgap of the semiconductor material, referred to as Z_{1/2} and EH_{6/7}, located at 0.65 eV and 1.6 eV below the conduction band edge (E_{C}), respectively. As the level of Z_{1/2} defects is particularly close to the conduction band edge, it acts as a recombination center, affecting the lifetime, forward voltage drop of bipolar devices and leakage current in unipolar devices formed from such semiconductor materials.

In principle, it is possible to remove a carbon vacancy from an epitaxial layer as-grown as shown in Figure 27.

A semiconductor device 1 comprises a 4H-SiC epitaxial layer 2 grown on a surface of a substrate 5 in a [0001] crystallographic axis direction X, as defined by Miller-Bravais indices. The [0001] crystallographic axis typically corresponds to the normal direction of the surface of the substrate 5. As-grown, the epitaxial layer 2 will comprise a number of carbon vacancies V_{C} throughout the 4H-SiC epitaxial layer 2. To reduce the concentration of carbon vacancy V_{C}, a top surface area 4a is either oxidized at a temperature of 1050 to 1400°C. Alternatively, a shallow carbon ions may be implanted into the top surface area 4a of SiC epitaxial layer 2. Either approach will in the introduction of carbon interstitials C_{I} into the 4H-SiC epitaxial layer 2. Then, the epitaxial layer 2 is annealed at a temperature in excess of 1500°C, resulting in a diffusion of the carbon interstitials C_{I} throughout the epitaxial layer 2. The carbon interstitials C_{I} can then recombine with the carbon vacancies V_{C}. Consequently, the epitaxial layer 2 will have a reduced carbon vacancy concentration.

As shown in Figure 27, Carbon implantation is performed parallel to the [0001] crystallographic axis. After diffusion of carbon interstitials C_{I}, reactive ion etching (RIE) or chemical mechanical polishing (CMP) is used in order to remove the C-implanted layer formed in the top surface area 4a. A similar situation would occur if oxidation is employed for carbon vacancy V_{C} reduction, where the oxide layer needs to be removed using hydrofluoric acid (HF).

Thus, the method for reducing carbon vacancy described above can only be carried out relatively early in a manufacturing processes, e.g. on the epitaxial layer 2 as-received. While this results in a 4H-SiC epitaxial layer 2 having a reduced concentration of carbon vacancies V_{C} towards the start of the manufacturing of a semiconductor device 1, subsequent processing steps such as activation of a highly doped p+ area or annealing of electrodes of an semiconductor circuit component, result in a regeneration of carbon vacancies V_{C} in the epitaxial layer 2. Once the carbon vacancies V_{C} have been re-generated, a second Carbon ion implantation cannot be performed, as this would require implanting Carbon into electrically active areas of the semiconductor device, such as an anode area or electrode. Moreover, oxidation cannot be performed, as this would consume parts of the active circuit structures in case of relatively thick epitaxial layers 2, e.g. epitaxial layers 2 having a thickness of 100 µm or more.

The present disclosure aims to describe alternative methods and devices having a reduced carbon vacancy concentration as compared to an epitaxial layer as-grown.

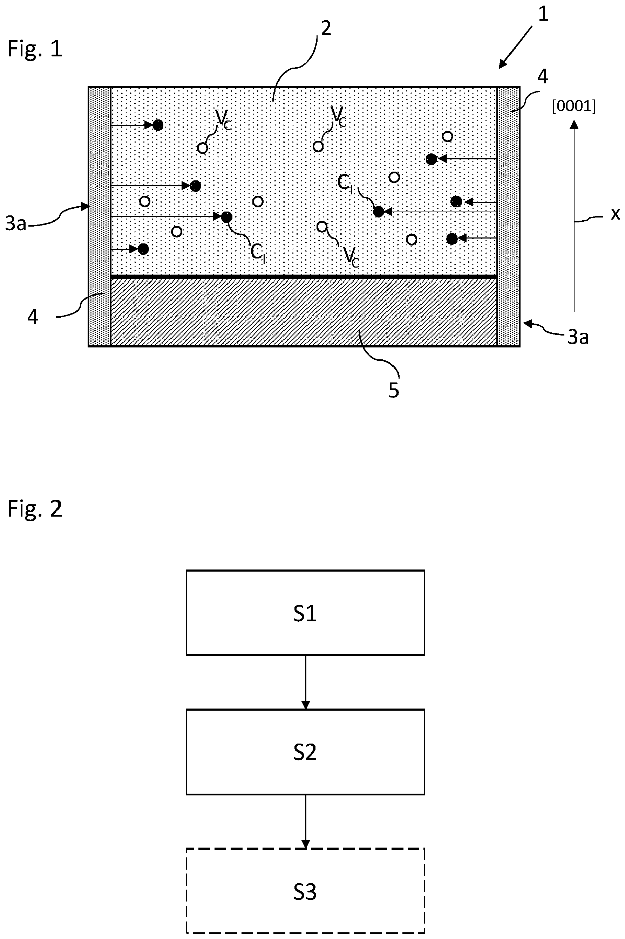

Figure 1 shows a semiconductor device 1 according to an embodiment of the present disclosure. Steps S1 to S3 of a method for reducing carbon vacancy V_{C} of an epitaxial layer 2 of the semiconductor device 1 are shown in Figure 2.

In a step S1, the epitaxial layer 2 is grown on a substrate 5 or other epitaxial layer (not shown). Initially, the epitaxial layer 2 will comprise a relatively high concentration of carbon vacancy V_{C}. For example, untreated n-type 4H-SiC semiconductor material of the epitaxial layer 2 may have comprise 10¹² Z_{1/2} defects per cm³.

Thus, in step S2, ions, for example carbon (C) ions, aluminum (Al) ions or silicon (Si) ions, are implanted through a sidewall 3a to form an implantation area 4 in the semiconductor material. Contrary to the situation shown in Figure 27, in the embodiment shown in Figure 1, ions are implanted through sidewalls 3a to form implantation areas 4 in a plane perpendicular to a top surface of the semiconductor device. That is to say, the implantation direction is perpendicular to the [0001] crystallographic axis direction X of the epitaxial layer 2. The side implantation may be performed at room temperature.

In the embodiment shown in Figure 1, carbon ions are implanted through two opposite sidewalls 3a to form carbon interstitial C_{I} in two implantation areas 4. It is also possible to implant ions through a single sidewall 3a to form a single implantation area 4, or to implant ions through three or four sidewalls 31, for example all sidewalls of a rectangular semiconductor chip. In the described embodiment, side implantation of Carbon on a 3-5 x 10¹⁶ cm⁻³ N-doped epitaxial layer 2 was carried out. One or more side implantation energies can be chosen so that the implantation profile will be outside the active electric area of the semiconductor device 1. For example, three different implantation stages with energies in the range of 10 to 200 keV may be used. Side implantation doses can range from 10¹⁰ to 10¹⁶ cm⁻².

As shown in Figure 1, step S2 may be carried out immediately after growing the epitaxial layer S1. However, it is also possible to form the implantation areas 4 towards the end of manufacturing the semiconductor device 1 as later described with regard to various specific semiconductor devices.

Side implantation can be followed by an optional, separate diffusion step S3. For example, the epitaxial layer 2 may be annealed at temperatures in excess of 1000°C for periods between 1 minute and 10 hours depending on the thickness of the epitaxial layer 2. The thickness of the epitaxial layer 2 may lie in a range of 5 to 150 µm for example. In the described embodiment, the epitaxial layer 2 a relatively short annealing step is carried out at a temperature of 1500°C for a period of 5 minutes. During this period, the generated carbon interstitials C_{I} further diffuse throughout the epitaxial layer 2. Alternatively or in addition, proton irradiation may be used to further diffuse the generated carbon interstitials C_{I}. For example, proton irradiation at or below 10 keV may be used.

Alternatively, side implantation with no subsequent diffusion step can be carried out on a finished semiconductor component. For example, after implantation of carbon with energies equal or higher than 300 keV, sufficient diffusion of carbon interstitials C_{I} takes place without an additional diffusion step.

It has been found that point defects in crystal structure of the epitaxial layer 2 can migrate quickly and thus a relatively long distances perpendicular to the [0001] crystallographic axis direction X. For example, carbon interstitials can diffuse long distances perpendicular to [0001] direction after 10 keV proton irradiation even at room temperature. This in turn significantly reduces carbon vacancy V_{C} throughout the epitaxial layer 2. For example, using the parameters described above, a horizontal diffusion length of several millimeters can be achieved, resulting in a significant reduction of carbon vacancy V_{C} throughout the entire width of the epitaxial layer 2 of a semiconductor chip having an edge length of 5 mm, for example. For example, a concentration of carbon vacancies V_{C} may be reduced by two or more orders of magnitude as compared with the epitaxial layer 2 as-grown.

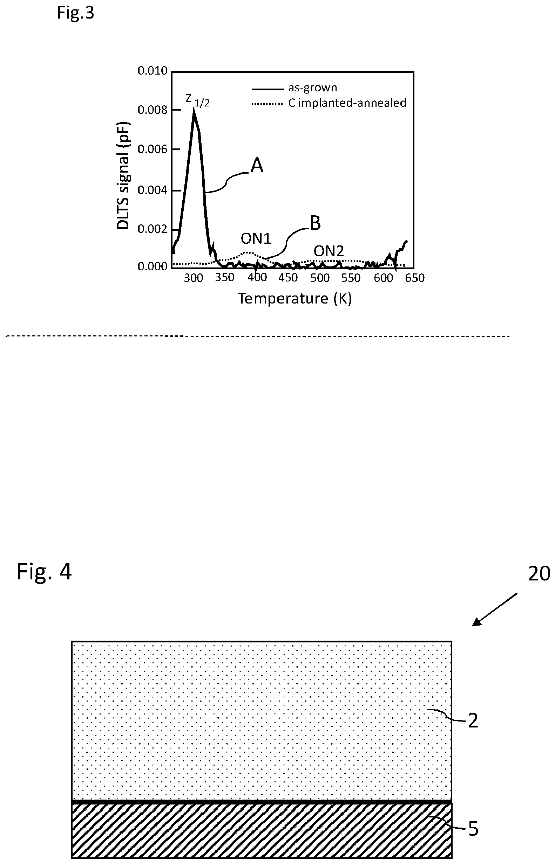

Figure 3 shows the result of deep level transient spectroscopy (DLTS) analysis of the semiconductor device 1 according to Figure 1. Therein, the curve with reference sign A shows a DLTS spectrum of untreated n-type 4H-SiC epitaxial layer 2 as-grown after step S1. The curve shows with reference sign B shows the DLTS spectrum of the epitaxial layer 2 after implantation of carbon ions in step S2 and annealing in step S3. As can be seen, after step S1, the untreated semiconductor device 1 comprises a relatively high concentration of carbon vacancy. Exemplarily, it comprises a concentration of Z_{1/2} defects in the order of 10¹²/cm³. As detailed above, the defect level Z_{1/2} is very close to the conduction band edge E_{C} and would therefore negatively affect the performance of a finished semiconductor device 1.

After implantation of carbon ions in step S2 and annealing of the epitaxial layer in step S3, no detectable amount of Z_{1/2} defects are present in the semiconductor device 1. In addition, as can be seen in Figure 3, the presence of so-called deep level ON1 and ON2 peaks that lie 0.84 eV and 1.1 eV below the conduction band edge E_{C}, respectively, can be detected. ON1 and ON2 levels are associated with carbon diffusion and typically detected after the implantation of carbon ions as described above with regard to Figure 27. Accordingly, side implantation of carbon ions through sidewalls 3a of a semiconductor device greatly reduce the concentration of carbon vacancy V_{C} of an epitaxial layer 2 with respect to the concentration of carbon vacancies V_{C} in the same epitaxial layer 2 as-grown.

In the following, manufacturing processes for various semiconductor devices 1 are described in more detail. The described processing steps will make apparent that a side implementation as described above with regard to Figures 1 and 2 provides an enhanced degree of flexibility in the manufacturing of semiconductor devices 1.

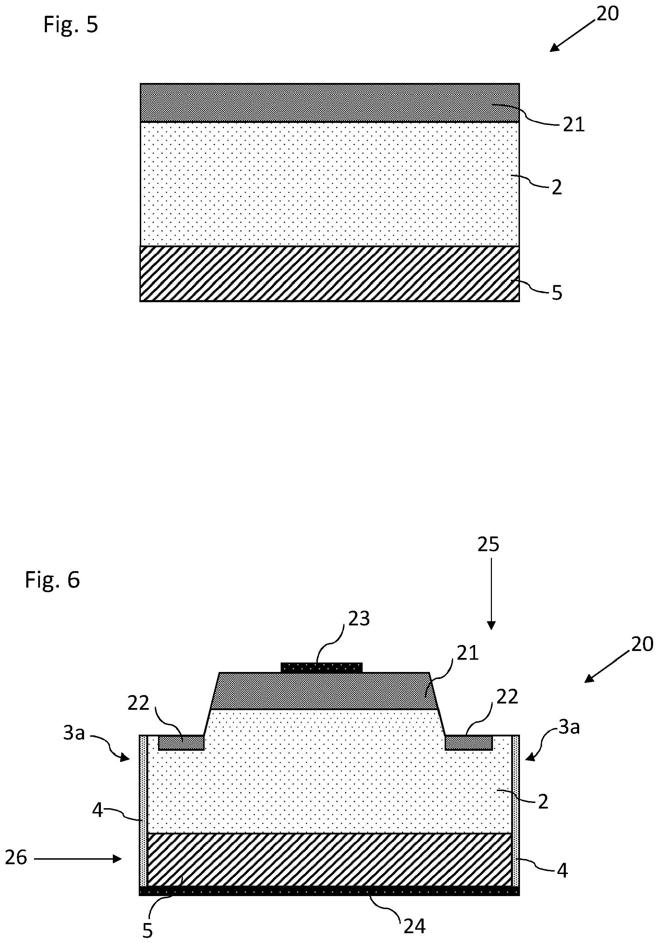

At first, processing steps for manufacturing a PIN diode 20 are shown with respect to Figures 4 to 6. In a first processing step shown in Figure 4, an n-type 4H-SiC epitaxial layer 2 is grown on a substrate 5. As described above, the epitaxial layer 2 will have a relatively high concentration of carbon vacancies V_{C}. In a next processing step shown in Figure 5, the epitaxial layer 2 is implanted with aluminum ions to form a highly doped p-type anode area 21. This is followed by a high temperature annealing step (not shown).

During the annealing, further carbon vacancies V_{C} are generated, even in the case carbon vacancies V_{C} had been previously removed.

Figure 6 shows the final p+-i-n structure of the PIN diode 20, further comprising implanted field relaxation layers 22 formed by conventional ion implantation. In addition, a metal anode electrode 23 and a metal cathode electrode 24 are formed on a top and bottom surface of the anode area 21 and the substrate 5, respectively. The anode electrode 23 and the cathode electrode 24 may be formed by electron-beam deposition. Forming of the field relaxation layers 22, the anode electrode 23 and the cathode electrode 24 may result in the generation of further carbon vacancies V_{C} in the epitaxial layer 2 acting as an intrinsic drift layer of the PIN diode 20.

To improve the performance of the PIN diode 20, and exemplarily of the n-type epitaxial layer 2, two implantation areas 4 are formed on the sidewalls 3a of the PIN diode 20 (also shown in Figure 6). Implantation of Carbon or other ions in the implantation areas 4 and optional subsequent annealing of the epitaxial layer 2 will result in a reduced carbon vacancy V_{C} concentration in the epitaxial layer 2 acting as a drift layer. This is indicated in Figure 6 by the lighter shading of the epitaxial layer 2.

As detailed above with Figure 3, the side implantation and subsequent annealing will also generate ON1 and ON2 levels. However, the presence of ON1 and ON2 levels in the epitaxial layer 2 does not influence the performance of the PIN diode 20.

In the described embodiment, forming of the field relaxation areas 22 is performed by frontside processing of the epitaxial layer 2 on a wafer or other substrate 5. Similarly, formation of the electrodes 23 and 24 is implemented by conventional metallization procedures from the front and back surfaces of the semiconductor device 1. For efficiency, typically a relatively large number of semiconductor devices 1, such as PIN diodes 20 are formed together on a common wafer or other substrate 5.

To implant ions in the vertical implantation areas 4, an area of the wafer or other substrate 5 corresponding to the PIN diode 20 may be separated from similar semiconductor circuit components grown on the same wafer or other substrate 5 by dicing. Thereby, individual semiconductor chips are formed, which may then be installed with the [0001] crystallographic axis pointing sideways into an ion implantation system to implant carbon ions through the sidewalls 3a of the individual semiconductor chips. For this purpose, a modified target holder carrying one or more semiconductor chips may be employed. During implantation, a first implantation direction 25 for implanting ions into the field relaxation area 22 of the epitaxial layer 2 is orthogonal to a second implantation direction 26 for implanting ions into the implantation area 4. Moreover, due to the side implantation, the implantation area 4 extends over the entire side surface of the semiconductor material, comprising the substrate 5 and the epitaxial layer 2.

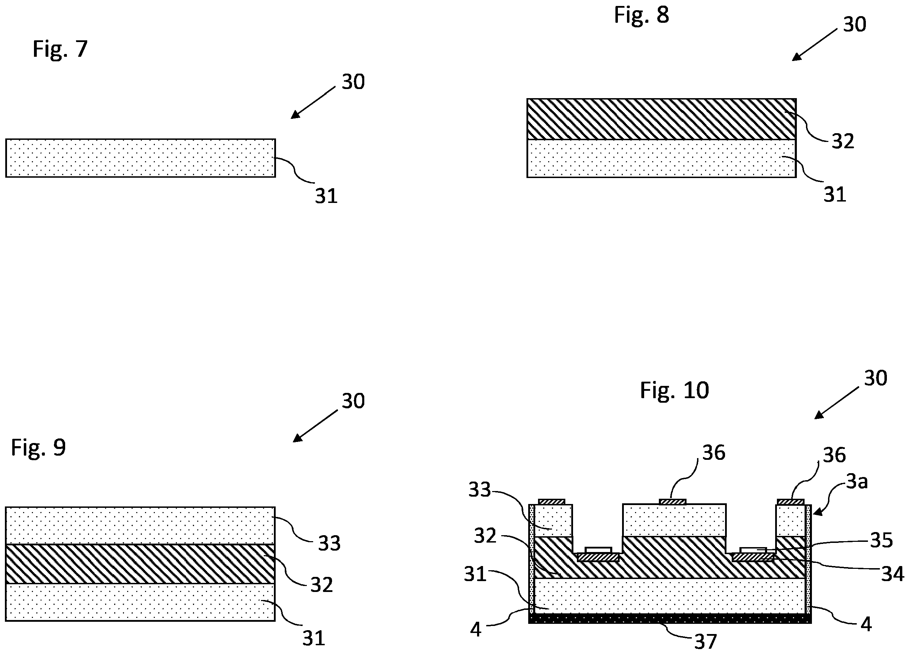

Figures 7 to 10 show processing steps for manufacturing a bipolar junction transistor (BJT) 30, exemplarily an NPN transistor, according to an embodiment of the present disclosure. In a first step shown in Figure 7, an n-type collector 31 made from a semiconductor material comprising carbon, such as 4H-SiC or 6H-SiC, is provided. Subsequently, a p-type base 32 is epitaxially grown on the n-type collector 31 (Figure 8). Then, an n-type emitter layer 33 is epitaxially grown on the p-type base 32 (Figure 9).

Subsequently, selected areas of the emitter 33 and corresponding top parts of the base 32 are etched to allow for the formation of gate electrodes as shown in Figure 10. At the base of the etched trenches, highly doped p-type layers 34 are formed in the p-type base 34. Thereafter, a gate electrode 35 is formed on a top surface of the highly doped p-type layer 34, an emitter electrode 36 is formed on a top surface of the n-type emitter 33, and a collector electrode 36 is formed on a bottom surface of the n-type collector 31.

The semiconductor material of both the n-type collector 31 as well as the n-type emitter 33 will comprise an increased concentration of carbon vacancies V_{C} present in the respective epitaxial layers 2 as-grown and/or further processed during a processing of the BJT 30. To reduce the carbon vacancy V_{C} in the collector 31 and emitter 33, implantation areas 4 are formed on sidewalls 3a of the BJT 30 as described above. The presence of the implantation areas 4 will result in the formation of carbon interstitials C_{I} and thus a reduction of the carbon vacancy V_{C}.

While the manufacturing method shown in Figures 7 to 10 has been described with respect to formation of an NPN BJT, similarly, a PNP BJT may be formed using the disclosed side implantation method, comprising a n-type base with a reduced carbon vacancy V_{C} after annealing with respect to the epitaxial layer later forming the base as-grown.

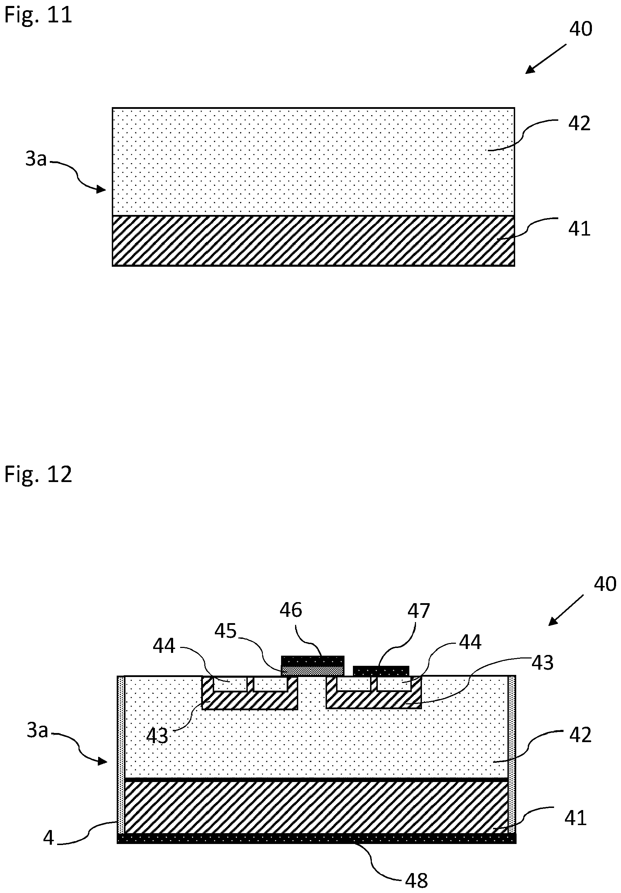

Figures 11 and 12 show two stages of manufacturing an insulated-gate bipolar transistor (IGBT) 40. Initially, an n-type base 42 made from 4H-SiC or 6H-SiC is epitaxially grown on a p-type collector 41, as shown in Figure 11.

As shown in Figure 12, within the n-type base 42, two p-type base wells 43 are formed by ion implantation through a top surface of the n-type base 42. Therein, a total of four n-type areas 44 are formed by either plasma immersion ion implantation (PIII) or conventional ion implantation.

Thereafter, an oxide layer 45, serving as electrical insulator, is formed in the central area of the n-type base 42 between right (inner) n-type area 44 of the left p-type base well 43 and the left (inner) n-type area 44 of the right p-type base well 43. On top of the oxide layer 45, an insulated gate electrode 46 is formed. Moreover, one or more emitter electrodes 47 are formed on top surface of the n-type areas 44. On the back surface of the p-type collector 41, a collector electrode 47 is formed. The electrodes 46, 47 and 48 may be formed by e-beam deposition.

Although not shown in Figure 12, a buffer layer can be present at the interface between the n-type base 42 and the p-type collector 41.

As detailed above, the n-type base layer 42 will have a high carbon vacancy V_{C} concentration after forming the IGBT 40. To reduce the unwanted point defects, implantation areas 4 are formed on sidewalls 3a of the IGBT 40 before annealing the n-type base 42. As described above, this will remove carbon vacancy V_{C} from the base 42 and result in the generation of ON1 and ON2 in the n-type layers 42 and 44. However, the generated ON1 and ON2 are not harmful for the manufactured semiconductor device, e.g. the IGBT 40. Moreover, although the process has been described for an IGBT 40 comprising an n-type base layer 42, the same applies for an IGBT fabricated starting from an n-type collector layer and having a p-type base layer.

It is noted that in the examples described above with reference to Figures 4 to 12, it is not necessary to remove the implantation areas 4 after device manufacturing. In each case, the implantation area 4 is placed outside an electrically active area of the respective semiconductor device 1. Thus, no additional RIE or CMP step is required as part of the disclosed manufacturing method, and the finished semiconductor device 1 may comprise a high concentration of the implanted species, such as carbon, in the implantation area 4. Even in the case that an part of the implantation area 4 comprising the implanted species is removed after annealing, for example by RIE or CMP of the sidewalls 3a of the finished semiconductor chip, a remaining implantation defect area of the implantation area 4 will still contain amorphous silicon indicative of the previous side implantation step. Similarly, compared to the oxidation method detailed above with respect to Figure 27, no long oxidation time and no long HF etching time are required.

The described methods and devices have further advantages. For example, carbon vacancy V_{C} can be reduced in epitaxial layers 2 of any thickness. The process is especially suited for very thick drift layers of more than 50um thickness. The method can be applied to both unipolar and bipolar devices. Some processing steps, such as annealing, can be carried out at lower temperatures compared to prior art methods.

The above steps for implanting ions through one or more sidewalls 3a of an individual semiconductor device 1 are particularly useful if the electrically active area of the finished device does not exceed the diffusion length of the implanted species. This will be the case for many typical power components, such as the PIN diode 20, the BJT 30 and the IGBT 40 described above. However, in the case of relatively large electrically active areas or in the case that carbon vacancy V_{C} removal is required before separation of individual semiconductor circuit component, an implantation through a sidewall of the epitaxial layer 2 can also be achieved using one or more trenches formed in an epitaxial layer 2 as described in further detail below. This may also be used in semiconductor devices, in which trenches are formed throughout a normal manufacturing process anyhow.

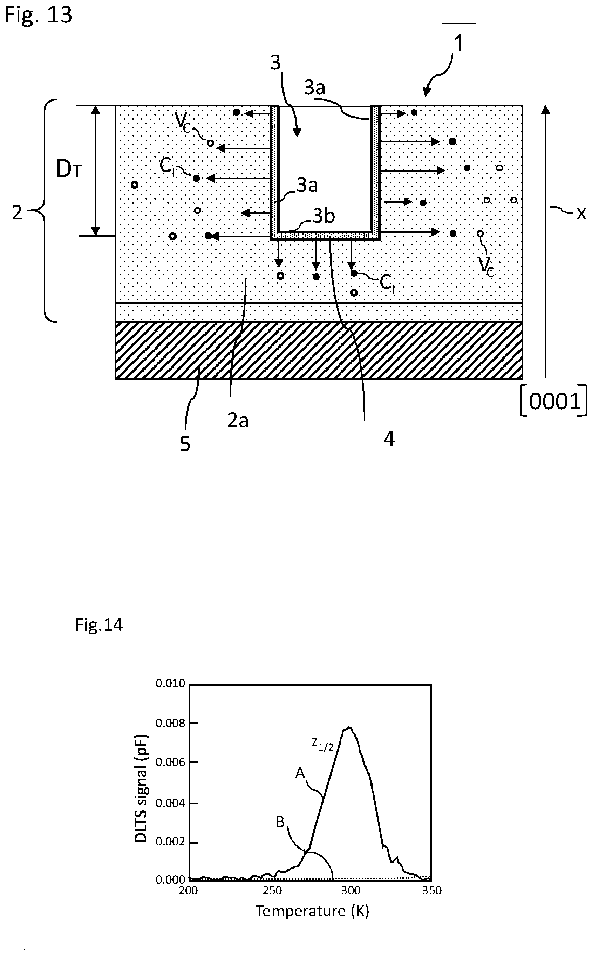

Figure 13 schematically shows a cross-sectional view of a semiconductor device 1 according to an embodiment of the disclosure. The semiconductor device 1 comprises an epitaxial layer 2 of a reduced concentration of carbon vacancy Vc. The semiconductor device 1 comprises, besides the epitaxial layer 2, a trench 3 extending in the epitaxial layer 2. The trench 3 comprises an implantation layer 4 in form of an implanted carbon layer, which is provided on the trench sidewalls 3a and a trench bottom 3b. Instead of carbon (C), one of boron (B), aluminum (Al), germanium (Ge), nitrogen (N), phosphorus (P), arsenic (As), oxygen (O), sulfur (S), hydrogen (H), argon (Ar) or silicon (Si) may be implanted.

For example, the implantation may be performed by plasma immersion ion implantation (PIII). PIII can also be performed on the top surface of the epitaxial layer 2, e.g. the main or front surface of the epitaxial layer 2, at which the trench 3 opens. Thus, PIII can also be performed parallel to the [0001] crystallographic axis (not shown in Figure 13). If PIII is applied at the front surface of the epitaxial layer 2, the formed PIII sublayer needs to be removed later by dry etching. However, as detailed below, this is not necessary for surfaces within the trench 3.

The epitaxial layer 2 comprises an epitaxial sublayer 2a of a reduced concentration of carbon vacancy Vc. As shown, the epitaxial sublayer 2a of the reduced concentration of carbon vacancy Vc extends perpendicular to a [0001] crystallographic axis and parallel to this axis, and a thickness of the epitaxial sublayer 2a of the reduced carbon vacancy at least corresponds to a depth D_{T} of the trench 3.

Without any treatment, the epitaxial layer 2 based on Silicon Carbon (SiC) comprises an amount of electrically active levels, corresponding to the carbon vacancy (Vc) concentration, which cannot be neglected. In Figure 13, unfilled circles in the epitaxial layer are shown to illustrate the occurrence of carbon vacancy V_{C} as detailed above.

The inventors have found that after plasma immersion ion implantation of a suitable species, such as B, Al, C, Si, Ge, N, P, As, O, S, F, H or Ar, and annealing the implantation area at 1600°C, carbon vacancies V_{C} can be removed in an area of the epitaxial layer 2 below the implantation surface, for example a sublayer of 100 µm thickness along the [0001] crystallographic axis. However, as detailed above, in a direction perpendicular to the [0001] crystallographic axis, carbon vacancies V_{C} can be removed over a much larger distance. For example, a horizontal diffusion length of several millimeters can be achieved. The PIII implanted species are confined in a relatively small space, for example a sublayer having a thickness of less than 50 nm. This causes stress that releases C_{I}.

According to the exemplary embodiment of Figure 13, the epitaxial layer 2 comprises the trench 3 with the implantation layer 4. The carbon layer 4, for example, has a thickness of less than 50 nm. As detailed above, the PIII carbon in the trench sidewalls 3a and trench bottom 3b provides carbon interstitials C_{I}, which are defects, and which can migrate perpendicular to the [0001] crystallographic axis and recombine with the electrically active defects providing the carbon vacancy Vc as detailed above. In Figure 13, filled circles in the epitaxial layer 2 are shown to illustrate the carbon interstitials C_{I}.

In Figure 13, the trench 3 extends parallel to or along the [0001] crystallographic axis of the epitaxial layer 2. The trench 3 may also extend at an angle α relative to the [0001] crystallographic axis. In such case, the thickness of the epitaxial sublayer 2a and the depth of the trench 3 are defined by L = D cos (α).

In this context, L is a length of the PIII carbon layer 4 from a trench inlet to a trench ending. In the exemplary embodiment of Figure 13, L corresponds to the trench depth D_{T}. D is a distance, which is measured parallel to the [0001] crystallographic axis, from a beginning of the implantation layer 4 to an ending of the implantation layer 4 in the trench 3. In the exemplary embodiment of Figure 13, D corresponds to the trench depth D_{T}. α is an angle between L and D. In the exemplary embodiment of Figure 13, α is zero.

Figure 14 schematically shows a deep level transient spectroscopy (DLTS) spectrum of an epitaxial layer 2 being treated by a method according to an embodiment. The epitaxial layer 2 is made of 4H-SiC. The DLTS spectrum is shown for the epitaxial layer 2 with and without Carbon diffusion perpendicular to the [0001] crystallographic axis. The curve indicated by the reference sign A represents the DLTS spectrum in untreated material, that means the level Z_{1/2} is in a range of 10¹² 1/cm³. The curve indicated by the reference sign B represents the DLTS spectrum after implantation. It can be seen that no level Z_{1/2} defects can be detected. Thus, as the Figure 14 shows, after diffusion, the concentration of the level Z_{1/2}, that means the negative charge state of the electrically active defects providing the carbon vacancy V_{C}, is below a detection limit.

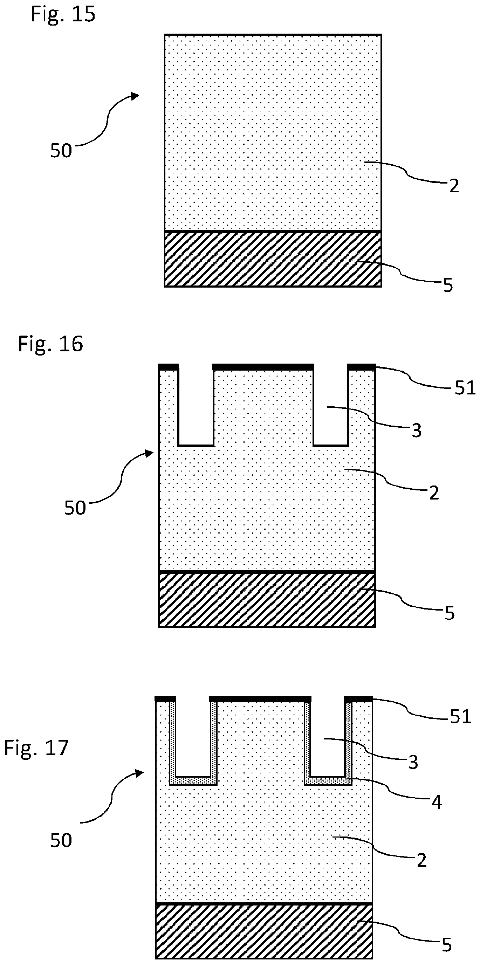

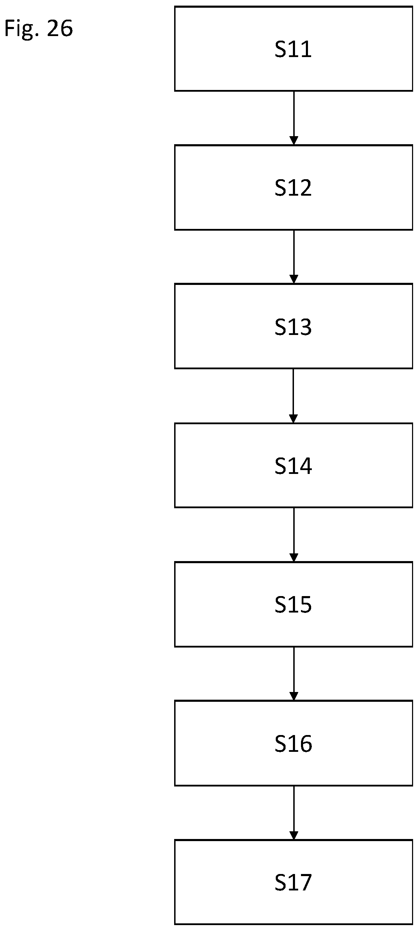

A manufacturing method according to an embodiment will be explained based on the flow diagram of Figure 26 and specific embodiments as shown in Figures 15 to 19. The manufacturing method is suitable for providing a semiconductor device 1 with an epitaxial layer 2 with a reduced concentration of electrically active carbon levels in the epitaxial layer 2. The semiconductor device 1 produced according to the steps shown in Figures 3 to 7 is a Junction Barrier Schottky (JBS) diode 50.

According to a step S12, the method comprises providing an epitaxial layer 2 on a substrate 5 (see Figure 26 and Figure 15). The embodiment of Figure 15 shows an n-type 4H-SiC epitaxial layer 2 with a doping concentration in a range from 10¹⁴ 1/cm³ to 10¹⁶ 1/cm³ being grown on a 4H-SiC substrate with a doping concentration of 10¹⁸ 1/cm³. The epitaxial layer thickness and doping are selected according to a voltage class of the semiconductor device 1.

According to a step S12, the method comprises providing a photoresist layer 51 on the epitaxial layer 2 (see Figure 26 and Figure 16) and exposing the photoresist layer 51 with electromagnetic radiation using a mask (not depicted). For example, the photoresist layer 51 being deposited on the epitaxial layer surface is patterned by photolithography according to the desired shape/dimensions of the trenches 3 which are provided in a subsequent step.

According to a step S13, the method comprises providing two trenches 3 in the epitaxial layer 2 (see Figure 26 and Figure 16). For example, the epitaxial layer 2 is etched by reactive ion etching (RIE) in order to form the trenches 3. The trenches 2 can have any cross section, such as square, round, rectangular, or polygonal. If D_{T} is the depth of the trench 3 and 1 the width of the cross section, deep trenches 3 (D_{T}>>1) can also be formed.

According to a step S14, the method comprises implanting carbon or another suitable species in each of the trenches 3 (see Figure 26 and Figure 17). In the described example, the trench sidewalls 3a and the trench bottom 3b of the trenches 3 are implanted with Carbon by plasma immersion ion implantation (PIII) to obtain the maximum doping concentration but not exceeding a solubility limit.

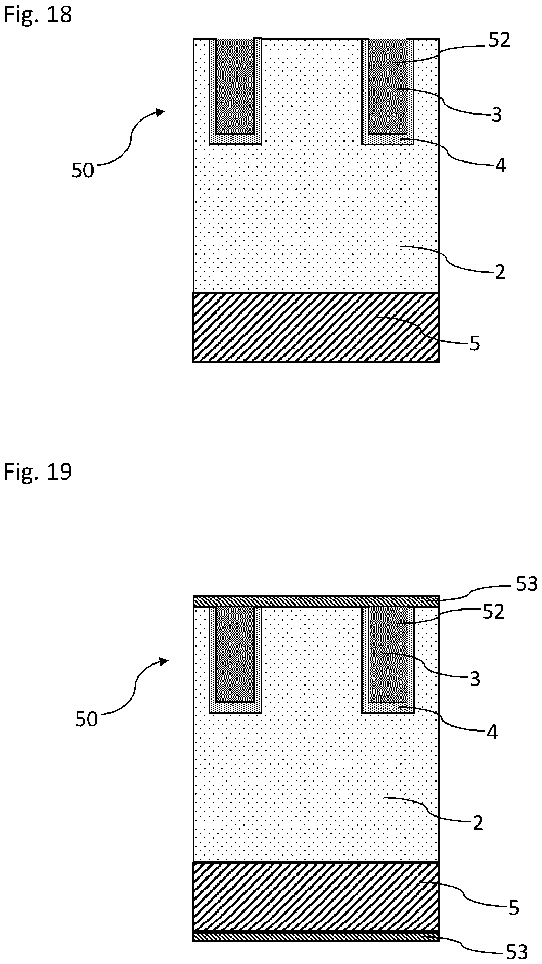

According to a step S15, the method comprises filling the trenches 3 with p-type polysilicon 52 (see Figure 26 and Figure 18). The step of filling the trenches 3 with p-type polysilicon 52 may be, alternatively, carried out after removing the photoresist layer 51 (see description in the context of step S16 below). As detailed later, filling the trenches 3 may assist in forming contacts, and generally will improve the mechanical stability of the finished semiconductor device 1.

According to a step S16, the method comprises carrying out an annealing process such that carbon ion diffusion from the at least one trench 3 perpendicular and/or parallel to a crystallographic [0001] axis of the at least one epitaxial layer 2 is induced (see Figure 26; the diffusion process is not illustrated in Figure 18; Figure 13 illustrates the diffusion process of the carbon interstitials C_{I}). For example, Carbon is diffused by annealing at a temperature of less than 1600 °C for a time in the range from 5 minutes to 600 minutes. Subsequently, oxygen plasma ashing is, for example, employed to remove the photoresist layer 51.

Alternatively, the photoresist layer 51 can be removed after PIII in steps S14, and a graphitic cap is then formed on the epitaxial layer surface so to ensure low surface roughness on the trench walls 3a during activation. After annealing, a graphitic cap can be removed by oxygen plasma ashing.

Following Carbon diffusion, the epitaxial layer 2 has a V_{C} concentration below the detection limit.

According to a step S17, the method comprises providing contact layers 53 according to a functioning of the semiconductor device 1. In the exemplary embodiment, metal is deposited on an epitaxial layer surface and on a backside for Schottky/ohmic contact formation.

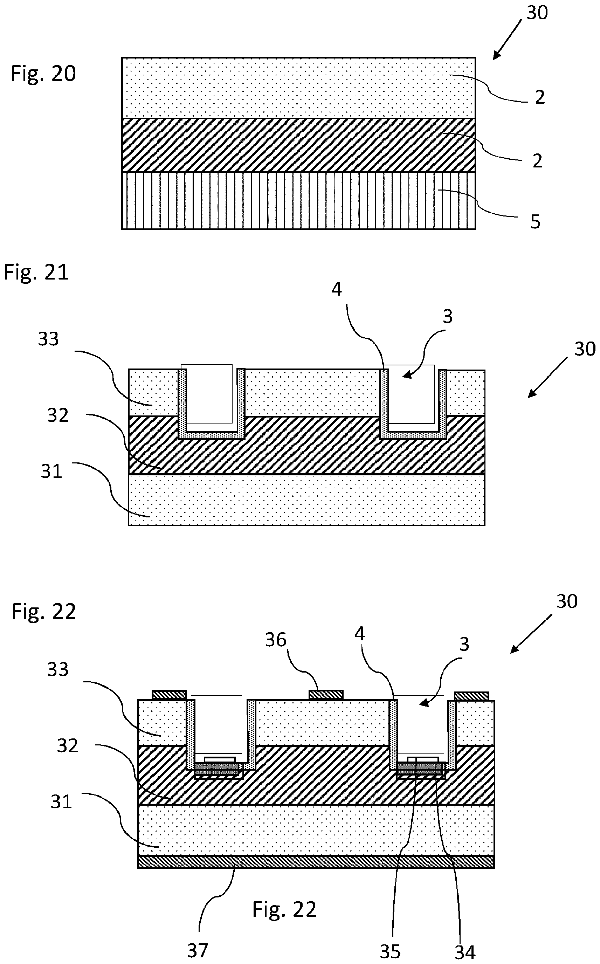

The manufacturing method according to the embodiment of Figure 26 will also be described based on the Figures 20 to 22. The semiconductor device 1 produced according to the steps shown in Figures 20 to 22 is a Bipolar Junction Transistor (BJT) 30. In the exemplary embodiment, the BJT 30 is an NPN transistor.

Figure 20 schematically shows a first step of the method for producing the BJT 30. Two epitaxial layers 2 are provided, which are grown on a substrate 5. The Figure 20 shows an upper n-type 4H-SiC epitaxial layer 2 with a doping concentration in a range from 10¹⁴ 1/cm³ to 10¹⁶ 1/cm³. It is grown on a middle epitaxial p-type epitaxial layer 2 with a doping concentration in a range from 10¹⁴ 1/cm³ to 10¹⁶ 1/cm³ on top of a 4H-SiC substrate 5 with a doping concentration of 10¹⁸ 1/cm³. The layer thicknesses and doping concentrations are selected according to the voltage class of the BJT 30.

Figure 21 schematically shows a second step of the method for producing the BJT 30. The epitaxial layers 2 are etched by reactive ion etching (RIE) in order to form two trenches 3. The trenches 3 can have any cross section, such as square, round, rectangular, or polygonal. Carbon is implanted in the trenches 3 by PIII and later diffused by annealing. After Carbon diffusion the upper epitaxial layer 2 corresponding to the n-type emitter 33 as well as the substrate 5 corresponding to the n-type collector 31 have a low carbon vacancy concentration. Trench sidewalls 3a and an epitaxial layer top can be protected by a graphitic cap.

Figure 22 schematically shows a third step of a method for producing the BJT 30. In this step, oxygen plasma ashing is employed to remove the graphitic cap. Last, high-doped p-type layers 34 are formed and metal is deposited for providing gate electrodes 35, emitter electrodes 36, and collector electrodes 37.

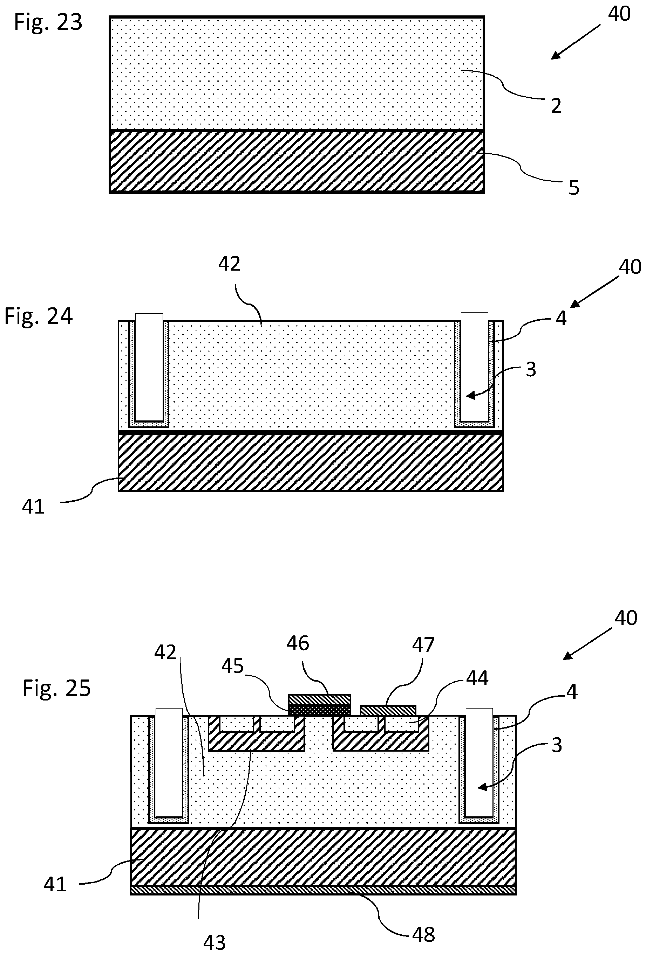

The manufacturing method according to the embodiment of Figure 26 will also be described based on the Figures 11 to 13. The semiconductor device 1 produced according to the steps shown in Figures 23 to 25 is an insulated-gate bipolar transistor (IGBT) 40.

Figure 23 schematically shows a first step of the method for producing the IGBT 40. The Figure 23 shows an n-type 4H-SiC epitaxial layer 2 with a doping concentration in a range from 10¹⁴ 1/cm³ to 10¹⁶ 1/cm³ on top of a 4H-SiC substrate 5 with a doping concentration of 10¹⁸ 1/cm³. The epitaxial layer and substrate thicknesses and doping concentrations are selected according to the voltage class of the IGBT 40.

Figure 24 schematically shows a second step of the method for producing the IGBT 40. The epitaxial layer 2 is etched by reactive ion etching (RIE) in order to form two trenches 3. In this example, a depth D_{T} of the trenches 3 corresponds to a thickness of the epitaxial layer 2. A relatively deep trench 3 as shown in Figure 24 assists in removing carbon vacancies throughout a relatively thick epitaxial layer 2. The trenches 3 can have any cross section, such as square, round, rectangular, or polygonal. Carbon is implanted in the trenches 3 by PIII and later diffused by annealing. After Carbon diffusion the epitaxial layer 2 comprising an n-type base 42 has a low carbon vacancy concentration. The trench sidewalls 3a and an epitaxial layer top can be protected by a graphitic cap.

Figure 25 schematically shows a third step of the method for producing the IGBT 40. In this step, oxygen plasma ashing is employed to remove the graphitic cap. Two p-type base well 43 are formed by ion implantation and a total of four n-type areas 44 are formed inside them by either PIII or by ion implantation. Ion implantation would be carried out in a state, in which the device manufacturing is in the state shown in Figure 24. At last, a gate electrode 46, an emitter electrode 47, and a collector electrode 48 are formed by e-beam deposition. The gate electrode 48 is provided with an oxide layer 45, which insulated the gate from the epitaxial layer 2 with the active electrical areas formed therein. A buffer layer can also be provided at the base/collector interface (not shown in Figure 25).

The embodiments shown in the Figures 1 to 26 as stated represent exemplary embodiments of improved semiconductor devices and methods for their manufacturing. Therefore, they do not constitute a complete list of all embodiments according to the improved methods. Actual devices and methods may vary from the embodiments shown in terms of specific semiconductor material, doped areas and electrical electrodes, for example. The scope of the invention is defined solely by the appended claims.

### Reference Signs

- 1: semiconductor device
- 2: epitaxial layer
- 2a: epitaxial sublayer
- 3: trench
- 3a: sidewall
- 3b: trench bottom
- 4: implantation area
- 4a: top surface area
- 5: substrate

- 20: PIN diode
- 21: anode area
- 22: field relaxation area
- 23: anode electrode
- 24: cathode electrode
- 25: first implantation direction
- 26: second implantation direction

- 30: BJT
- 31: collector
- 32: base
- 33: emitter
- 34: highly doped p-type layer
- 35: gate electrode
- 36: emitter electrode
- 37: collector electrode

- 40: IGBT
- 41: collector
- 42: base
- 43: p-type base well
- 44: n-type area
- 45: oxide layer
- 46: gate electrode
- 47: emitter electrode
- 48: collector electrode

- 50: JBS diode
- 51: photoresist layer
- 52: p-type polysilicon
- 53: contact layer

- A: DLTS spectrum of untreated epitaxial layer
- B: DLTS spectrum of annealed epitaxial layer
- Ci: carbon interstitials
- D_{T}: trench depth
- V_{C}: carbon vacancy
- X: crystallographic axis direction

## Claims

1. A method for manufacturing a semiconductor device (1), comprising:
- growing at least one epitaxial layer (2), the at least one epitaxial layer (2) made from a first semiconductor material having a [0001] crystallographic axis and comprising at least one of n-type 4H-SiC or n-type 6H-SiC semiconductor material; and
- implanting ions, comprising at least one of carbon ions and silicon ions, through at least one sidewall (3a) of the at least one epitaxial layer (2) in a direction perpendicular to the [0001] crystallographic axis to form at least one implantation area (4), thereby reducing a concentration of carbon vacancies (V_{C}) in the first semiconductor material with respect to the at least one epitaxial layer (2) as-grown, such that the respective first semiconductor material of the finished semiconductor device (1) has a concentration of carbon vacancy Z_{1/2} of below 10¹⁰/cm³.

2. The method of claim 1, further comprising at least one of:
- annealing the at least one epitaxial layer (2) to further reduce a concentration of carbon vacancies (V_{C}) in the first semiconductor material with respect to the at least one epitaxial layer (2) after implanting ions; or
- proton irradiating the at least one epitaxial layer (2) to further reduce a concentration of carbon vacancies (V_{C}) in the first semiconductor material with respect to the at least one epitaxial layer (2) after implanting ions.

3. The method of claim 1 or 2, before implanting ions through at least one sidewall (3a), the method further comprises:
- performing a plurality of processing steps to form at least one semiconductor circuit component comprising at least parts of the at least one epitaxial layer (2); and
- separating the at least one semiconductor circuit component to obtain a semiconductor chip having a top surface perpendicular to the [0001] crystallographic axis and a plurality of sidewalls (3a) perpendicular to the top surface.

4. The method of claim 3, comprising:
- forming a plurality of semiconductor circuit components on a carrier substrate (5) carrying the at least one epitaxial layer (2);
- separating the plurality of semiconductor circuit components by dicing the carrier substrate (5) carrying the at least one epitaxial layer (2) along at least one cut surface perpendicular to the [0001] crystallographic axis; and
- implanting the ions through the at least one cut surface.

5. The method of claim 3 or 4, wherein
- forming at least one semiconductor circuit component comprises implanting at least one first species through a surface of the at least one epitaxial layer (2) in a first implantation direction (25) parallel to the [0001] crystallographic axis before separating the at least one semiconductor circuit component; and
- implanting ions through at least one sidewall (3a) comprises implanting at least one second species through the at least one sidewall (3a) of the at least one epitaxial layer (2) in a second implantation direction (26) orthogonal to the first implantation direction (25) after separating the at least one semiconductor circuit component.

6. The method of claim 1 or 2, further comprising:
- forming at least one trench (3) having two sidewalls (3a) within the at least one epitaxial layer (2),
- wherein implanting ions through at least one sidewall (3a) comprises plasma immersion ion implanting, PIII, of at least one of carbon ions or silicon ions through the two sidewalls (3a) of the at least one trench (3).

7. The method of claim 6, further comprising:
- filling the at least one trench (3) after PIII; and
- forming at least one contact layer (53) on a top surface of the at least one epitaxial layer (2) after filling the at least one trench (3).

8. The method of claim 6, further comprising:
- forming at least one electrode at a bottom surface (3b) of the at least one trench (3).

9. The method of any one of claims 1 to 8, before implanting ions through the at least one sidewall (3a), the method further comprises:
- depositing at least one metal material on a surface of the at least one epitaxial layer (2); and
- annealing the at least one metal material to form an electrode, thereby increasing a concentration of carbon vacancies (V_{C}) in the first semiconductor material.

10. A semiconductor device (1), comprising:
- at least one epitaxial layer (2) made from a first semiconductor material having a [0001] crystallographic axis and comprising at least one of n-type 4H-SiC or n-type 6H-SiC semiconductor material; and
- at least one implantation area (4) formed at a sidewall (3a) of the epitaxial layer (2), a normal direction of the sidewall (3a) being perpendicular to the [0001] crystallographic axis, the at least one implantation area (4) comprising an implanted species, comprising at least one of carbon ions or silicon ions;
- wherein at least one part of the epitaxial layer (2) adjacent to the sidewall (3a) has a reduced concentration of carbon vacancies (V_{C}) with a concentration of carbon vacancy Z_{1/2} of below 10¹⁰/cm³. , wherein the semiconductor device is manufactured according to the method of claim 1.

11. The semiconductor device (1) of claim 10, comprising at least one semiconductor chip comprising the at least one epitaxial layer (2), wherein the at least one implantation area (4) is formed on at least one of a plurality of sidewalls (3a) of the at least one semiconductor chip.

12. The semiconductor device (1) of claim 10, comprising at least one trench (3) having two sidewalls (3a) formed in the at least one epitaxial layer (2), wherein
- the at least one implantation area (4) is formed on at least one of the two sidewalls (3a) of the at least one trench (3),
- the at least one part of the epitaxial layer (2) corresponds to a sublayer (2a) extending in a plane perpendicular to the [0001] crystallographic axis, and
- a thickness of the sublayer (2a) corresponds to or exceeds a depth (D_{T}) of the at least one trench (3).

13. The semiconductor device (1) of any one of claims 10 to 12, further comprising:
- at least one electrode formed on a top or bottom surface of the at least one epitaxial layer (2), thereby forming an electrically active area, wherein the at least one implantation area (4) is formed outside of the electrically active area.

14. The semiconductor device (1) of any one of claims 10 to 13, wherein the at least one implantation area (4) comprises an implantation defect area, comprising amorphous silicon.

15. The semiconductor device (1) of any one of claims 10 to 14, wherein the semiconductor device (1) comprises at least one of:
- a PIN diode (20) comprising a drift layer, wherein the at least one epitaxial layer (2) comprises the drift layer;
- a BJT (30) comprising an emitter (33), a collector (31) and a base (32), wherein the at least one epitaxial layer (2) comprises at least one of the emitter (33), the collector (31) or the base (32);
- an IGBT (40) comprising a base (42) formed from the first semiconductor material, wherein the at least one epitaxial layer (2) comprises the base (42); or
- a JBS diode (50) comprising a semiconductor body formed from the first semiconductor material, wherein the at least one epitaxial layer (2) comprises the semiconductor body.

## Patentansprüche

1. Verfahren zum Herstellen eines Halbleiterbauelements (1), Folgendes umfassend:
- Aufwachsen mindestens einer epitaktischen Schicht (2), wobei die mindestens eine epitaktische Schicht (2) aus einem ersten Halbleitermaterial mit einer kristallographischen Achse [0001] angefertigt ist und mindestens eines von einem n-leitenden 4H-SiC- oder einem n-leitenden 6H-SiC-Halbleitermaterial umfasst; und
- Implantieren von Ionen, umfassend mindestens eine Sorte aus Kohlenstoff-Ionen und Silizium-Ionen, durch mindestens eine Seitenwand (3a) der mindestens einen epitaktischen Schicht (2) in eine Richtung senkrecht zur kristallographischen Achse [0001], um mindestens einen Implantationsbereich (4) auszubilden, wodurch eine Konzentration von Kohlenstoff-Leerstellen (V_{C}) in dem ersten Halbleitermaterial hinsichtlich der mindestens einen aufgewachsenen epitaktischen Schicht (2) reduziert wird, so dass das jeweilige erste Halbleitermaterial des fertigen Halbleiterbauelements (1) eine Konzentration der Kohlenstoff-Leerstellen Z_{1/2} von unter 10¹⁰/cm³ aufweist.

2. Verfahren nach Anspruch 1, weiterhin mindestens eines des Folgenden umfassend:
- Tempern der mindestens einen epitaktischen Schicht (2), um eine Konzentration von Kohlenstoff-Leerstellen (V_{C}) in dem ersten Halbleitermaterial hinsichtlich der mindestens einen epitaktischen Schicht (2) nach Implantieren von Ionen weiter zu reduzieren; oder
- Protonen-Bestrahlen der mindestens einen epitaktischen Schicht (2), um eine Konzentration von Kohlenstoff-Leerstellen (V_{C}) in dem ersten Halbleitermaterial hinsichtlich der mindestens einen epitaktischen Schicht (2) nach Implantieren von Ionen weiter zu reduzieren.

3. Verfahren nach Anspruch 1 oder 2, wobei das Verfahren vor Implantieren von Ionen durch mindestens eine Seitenwand (3a) weiterhin Folgendes umfasst:
- Durchführen einer Vielzahl von Verarbeitungsschritten, um mindestens eine Halbleiterschaltungskomponente auszubilden, die mindestens Teile der mindestens einen epitaktischen Schicht (2) umfasst; und
- Trennen der mindestens einen Halbleiterschaltungskomponente, um einen Halbleiterchip mit einer oberen Oberfläche senkrecht zu der kristallographischen Achse [0001] und einer Vielzahl von Seitenwänden (3a) senkrecht zu der oberen Oberfläche zu erlangen.

4. Verfahren nach Anspruch 3, Folgendes umfassend:
- Ausbilden einer Vielzahl von Halbleiterschaltungskomponenten auf einem Trägersubstrat (5), das die mindestens eine epitaktische Schicht (2) trägt;
- Trennen der Vielzahl von Halbleiterschaltungskomponenten durch Zerteilen des Trägersubstrats (5), das die mindestens eine epitaktische Schicht (2) trägt, entlang mindestens einer Schnittfläche senkrecht zu der kristallographischen Achse [0001]; und
- Implantieren der Ionen durch die mindestens eine Schnittfläche.

5. Verfahren nach Anspruch 3 oder 4, wobei
- Ausbilden mindestens einer Halbleiterschaltungskomponente Implantieren mindestens einer ersten Spezies durch eine Oberfläche der mindestens einen epitaktischen Schicht (2) in eine erste Implantationsrichtung (25) parallel zu der kristallographischen Achse [0001] umfasst, bevor die mindestens eine Halbleiterschaltungskomponente getrennt wird; und
- Implantieren von Ionen durch mindestens eine Seitenwand (3a) Implantieren mindestens einer zweiten Spezies durch die mindestens eine Seitenwand (3a) der mindestens einen epitaktischen Schicht (2) in eine zweite Implantationsrichtung (26) orthogonal zu der ersten Implantationsrichtung (25) nach Trennen der mindestens einen Halbleiterschaltungskomponente umfasst.

6. Verfahren nach Anspruch 1 oder 2, weiterhin Folgendes umfassend:
- Ausbilden mindestens eines Grabens (3) mit zwei Seitenwänden (3a) innerhalb der mindestens einen epitaktischen Schicht (2),
- wobei Implantieren von Ionen durch mindestens eine Seitenwand (3a) Plasmaimmersions-Ionenimplantieren, PIII, von mindestens einer Sorte aus Kohlenstoff-Ionen oder Silizium-Ionen durch die beiden Seitenwände (3a) des mindestens einen Grabens (3) umfasst.

7. Verfahren nach Anspruch 6, weiterhin Folgendes umfassend:
- Füllen des mindestens einen Grabens (3) nach PIII; und
- Ausbilden mindestens einer Kontaktschicht (53) auf einer oberen Oberfläche der mindestens einen epitaktischen Schicht (2) nach Füllen des mindestens einen Grabens (3).

8. Verfahren nach Anspruch 6, weiterhin Folgendes umfassend:
- Ausbilden mindestens einer Elektrode an einer unteren Oberfläche (3b) des mindestens einen Grabens (3).

9. Verfahren nach einem der Ansprüche 1 bis 8, wobei das Verfahren vor Implantieren von Ionen durch die mindestens eine Seitenwand (3a) weiterhin Folgendes umfasst:
- Abscheiden mindestens eines Metallmaterials auf einer Oberfläche der mindestens einen epitaktischen Schicht (2); und
- Tempern des mindestens einen Metallmaterials, um eine Elektrode auszubilden, wodurch eine Konzentration von Kohlenstoff-Leerstellen (V_{C}) in dem ersten Halbleitermaterial erhöht wird.

10. Halbleiterbauelement (1), Folgendes umfassend:
- mindestens eine epitaktische Schicht (2), die aus einem ersten Halbleitermaterial mit einer kristallographischen Achse [0001] angefertigt ist und mindestens eines von einem n-leitenden 4H-SiC- oder einem n-leitenden 6H-SiC-Halbleitermaterial umfasst; und
- mindestens einen Implantationsbereich (4), der an einer Seitenwand (3a) der epitaktischen Schicht (2) ausgebildet ist, wobei eine Normale der Seitenwand (3a) senkrecht zu der kristallographischen Achse [0001] ist, wobei der mindestens eine Implantationsbereich (4) eine implantierte Spezies umfasst, die mindestens eine aus Kohlenstoff-Ionen oder Silizium-Ionen umfasst;
- wobei mindestens ein Teil der epitaktischen Schicht (2), der an die Seitenwand (3a) angrenzt, eine reduzierte Konzentration von Kohlenstoff-Leerstellen (V_{C}) mit einer Konzentration der Kohlenstoff-Leerstellen Z_{1/2} unter 10¹⁰/cm³ aufweist, wobei das Halbleiterbauelement nach dem Verfahren nach Anspruch 1 hergestellt ist.

11. Halbleiterbauelement (1) nach Anspruch 10, mindestens einen Halbleiterchip umfassend, der die mindestens eine epitaktische Schicht (2) umfasst, wobei der mindestens eine Implantationsbereich (4) auf mindestens einer Seitenwand aus einer Vielzahl von Seitenwänden (3a) des mindestens einen Halbleiterchips ausgebildet ist.

12. Halbleiterbauelement (1) nach Anspruch 10, mindestens einen Graben (3) mit zwei Seitenwänden (3a) umfassend, der in der mindestens einen epitaktischen Schicht (2) ausgebildet ist, wobei
- der mindestens eine Implantationsbereich (4) auf mindestens einer der beiden Seitenwände (3a) des mindestens einen Grabens (3) ausgebildet ist,
- der mindestens eine Teil der epitaktischen Schicht (2) einer Teilschicht (2a) entspricht, die sich in einer Ebene senkrecht zur kristallographischen Achse [0001] erstreckt, und
- eine Dicke der Teilschicht (2a) einer Tiefe (D_{T}) des mindestens einen Grabens (3) entspricht oder diese übersteigt.

13. Halbleiterbauelement (1) nach einem der Ansprüche 10 bis 12, weiterhin Folgendes umfassend:
- mindestens eine Elektrode, die auf einer oberen oder unteren Oberfläche der mindestens einen epitaktischen Schicht (2) ausgebildet ist, wodurch ein elektrisch aktiver Bereich ausgebildet wird, wobei der mindestens eine Implantationsbereich (4) außerhalb des elektrisch aktiven Bereichs ausgebildet wird.

14. Halbleiterbauelement (1) nach einem der Ansprüche 10 bis 13, wobei der mindestens eine Implantationsbereich (4) einen Implantationsdefektbereich umfasst, der amorphes Silizium umfasst.

15. Halbleiterbauelement (1) nach einem der Ansprüche 10 bis 14, wobei das Halbleiterbauelement (1) mindestens eines des Folgenden umfasst:
- eine PIN-Diode (20), die eine Driftschicht umfasst, wobei die mindestens eine epitaktische Schicht (2) die Driftschicht umfasst;
- einen BJT (30), umfassend einen Emitter (33), einen Kollektor (31) und eine Basis (32), wobei die mindestens eine epitaktische Schicht (2) mindestens ein Element aus dem Emitter (33), dem Kollektor (31) oder der Basis (32) umfasst;
- einen IGBT (40), eine Basis (42) umfassend, die aus dem ersten Halbleitermaterial ausgebildet ist, wobei die mindestens eine epitaktische Schicht (2) die Basis (42) umfasst; oder
- eine JBS-Diode (50), umfassend einen Halbleiterkörper, der aus dem ersten Halbleitermaterial ausgebildet ist, wobei die mindestens eine epitaktische Schicht (2) den Halbleiterkörper umfasst.

## Revendications

1. Procédé de fabrication d'un dispositif semi-conducteur (1), comprenant :
- la croissance d'au moins une couche épitaxiale (2), l'au moins une couche épitaxiale (2) étant élaborée à partir d'un premier matériau semi-conducteur ayant un axe cristallographique [0001] et comprenant un matériau semi-conducteur 4H-SiC de type n et/ou 6H-SiC de type n ; et
- l'implantation d'ions, comprenant des ions carbone et/ou des ions silicium, à travers au moins une paroi latérale (3a) de l'au moins une couche épitaxiale (2) dans une direction perpendiculaire à l'axe cristallographique [0001] pour former au moins une zone d'implantation (4), ce qui réduit ainsi une concentration de lacunes de carbone (V_{C}) dans le premier matériau semi-conducteur par rapport à l'au moins une couche épitaxiale (2) brute de croissance, de telle sorte que le premier matériau semi-conducteur respectif du dispositif semi-conducteur fini (1) a une concentration de lacunes de carbone Z_{1/2} inférieure à 10¹⁰/cm³.

2. Procédé selon la revendication 1, comprenant en outre :
- le recuit de l'au moins une couche épitaxiale (2) pour réduire encore une concentration de lacunes de carbone (V_{C}) dans le premier matériau semi-conducteur par rapport à l'au moins une couche épitaxiale (2) après l'implantation d'ions ; et/ou
- l'irradiation protonique de l'au moins une couche épitaxiale (2) pour réduire encore une concentration de lacunes de carbone (V_{C}) dans le premier matériau semi-conducteur par rapport à l'au moins une couche épitaxiale (2) après l'implantation d'ions.

3. Procédé selon la revendication 1 ou 2, le procédé comprenant en outre, avant l'implantation d'ions à travers au moins une paroi latérale (3a) :
- la réalisation d'une pluralité d'étapes de traitement pour former au moins un composant de circuit semi-conducteur comprenant au moins des parties de l'au moins une couche épitaxiale (2) ; et
- la séparation de l'au moins un composant de circuit semi-conducteur pour obtenir une puce semi-conductrice ayant une surface supérieure perpendiculaire à l'axe cristallographique [0001] et une pluralité de parois latérales (3a) perpendiculaires à la surface supérieure.

4. Procédé selon la revendication 3, comprenant :
- la formation d'une pluralité de composants de circuit semi-conducteurs sur un substrat de support (5) portant l'au moins une couche épitaxiale (2) ;
- la séparation de la pluralité de composants de circuit semi-conducteurs par découpe du substrat de support (5) portant l'au moins une couche épitaxiale (2) le long d'au moins une surface de découpe perpendiculaire à l'axe cristallographique [0001] ; et
- l'implantation des ions à travers l'au moins une surface de découpe.

5. Procédé selon la revendication 3 ou 4, dans lequel
- la formation d'au moins un composant de circuit semi-conducteur comprend l'implantation d'au moins une première espèce à travers une surface de l'au moins une couche épitaxiale (2) dans une première direction d'implantation (25) parallèle à l'axe cristallographique [0001] avant la séparation de l'au moins un composant de circuit semi-conducteur ; et
- l'implantation d'ions à travers au moins une paroi latérale (3a) comprend l'implantation d'au moins une deuxième espèce à travers l'au moins une paroi latérale (3a) de l'au moins une couche épitaxiale (2) dans une deuxième direction d'implantation (26) orthogonale à la première direction d'implantation (25) après la séparation de l'au moins un composant de circuit semi-conducteur.

6. Procédé selon la revendication 1 ou 2, comprenant en outre :
- la formation d'au moins une tranchée (3) ayant deux parois latérales (3a) à l'intérieur de l'au moins une couche épitaxiale (2),
- dans lequel l'implantation d'ions à travers au moins une paroi latérale (3a) comprend une implantation ionique par immersion plasma, PIII, d'ions carbone et/ou d'ions silicium à travers les deux parois latérales (3a) de l'au moins une tranchée (3).

7. Procédé selon la revendication 6, comprenant en outre :
- le remplissage de l'au moins une tranchée (3) après la PIII ; et
- la formation d'au moins une couche de contact (53) sur une surface supérieure de l'au moins une couche épitaxiale (2) après le remplissage de l'au moins une tranchée (3).

8. Procédé selon la revendication 6, comprenant en outre :
- la formation d'au moins une électrode au niveau d'une surface inférieure (3b) de l'au moins une tranchée (3) .

9. Procédé selon l'une quelconque des revendications 1 à 8, le procédé comprenant en outre, avant l'implantation d'ions à travers l'au moins une paroi latérale (3a) :
- le dépôt d'au moins un matériau métallique sur une surface de l'au moins une couche épitaxiale (2) ; et
- le recuit de l'au moins un matériau métallique pour former une électrode, ce qui augmente ainsi une concentration de lacunes de carbone (V_{C}) dans le premier matériau semi-conducteur.

10. Dispositif semi-conducteur (1), comprenant :
- au moins une couche épitaxiale (2) élaborée à partir d'un premier matériau semi-conducteur ayant un axe cristallographique [0001] et comprenant un matériau semi-conducteur 4H-SiC de type n et/ou 6H-SiC de type n ; et
- au moins une zone d'implantation (4) formée au niveau d'une paroi latérale (3a) de la couche épitaxiale (2), une direction de la normale à la paroi latérale (3a) étant perpendiculaire à l'axe cristallographique [0001], l'au moins une zone d'implantation (4) comprenant une espèce implantée, comprenant des ions carbone et/ou des ions silicium ;
- dans lequel au moins une partie de la couche épitaxiale (2) adjacente à la paroi latérale (3a) a une concentration réduite de lacunes de carbone (V_{C}) avec une concentration de lacunes de carbone Z_{1/2} inférieure à 10¹⁰/cm³, le dispositif semi-conducteur étant fabriqué selon le procédé de la revendication 1.

11. Dispositif semi-conducteur (1) selon la revendication 10, comprenant au moins une puce semi-conductrice comprenant l'au moins une couche épitaxiale (2), dans lequel l'au moins une zone d'implantation (4) est formée sur l'une au moins d'une pluralité de parois latérales (3a) de l'au moins une puce semi-conductrice.

12. Dispositif semi-conducteur (1) selon la revendication 10, comprenant au moins une tranchée (3) ayant deux parois latérales (3a) formées dans l'au moins une couche épitaxiale (2), dans lequel
- l'au moins une zone d'implantation (4) est formée sur au moins une des deux parois latérales (3a) de l'au moins une tranchée (3),
- l'au moins une partie de la couche épitaxiale (2) correspond à une sous-couche (2a) s'étendant dans un plan perpendiculaire à l'axe cristallographique [0001], et
- une épaisseur de la sous-couche (2a) correspond à ou dépasse une profondeur (D_{T}) de l'au moins une tranchée (3) .

13. Dispositif semi-conducteur (1) selon l'une quelconque des revendications 10 à 12, comprenant en outre :
- au moins une électrode formée sur une surface supérieure ou inférieure de l'au moins une couche épitaxiale (2), formant ainsi une zone électriquement active, dans lequel l'au moins une zone d'implantation (4) est formée à l'extérieur de la zone électriquement active.

14. Dispositif semi-conducteur (1) selon l'une quelconque des revendications 10 à 13, dans lequel l'au moins une zone d'implantation (4) comprend une zone de défaut d'implantation, comprenant du silicium amorphe.

15. Dispositif semi-conducteur (1) selon l'une quelconque des revendications 10 à 14, le dispositif semi-conducteur (1) comprenant au moins un élément parmi :
- une diode PIN (20) comprenant une couche de dérive, l'au moins une couche épitaxiale (2) comprenant la couche de dérive ;
- un BJT (30) comprenant un émetteur (33), un collecteur (31) et une base (32), l'au moins une couche épitaxiale (2) comprenant au moins un élément parmi l'émetteur (33), le collecteur (31) et la base (32) ;
- un IGBT (40) comprenant une base (42) formée à partir du premier matériau semi-conducteur, l'au moins une couche épitaxiale (2) comprenant la base (42) ; ou
- une diode JBS (50) comprenant un corps semi-conducteur formé à partir du premier matériau semi-conducteur, l'au moins une couche épitaxiale (2) comprenant le corps semi-conducteur.
